# EUROPÄISCHE PATENTSCHRIFT

(11) **EP 2 887 163 B1**
(45) Veröffentlichungstag und Bekanntmachung des Hinweises auf die Patenterteilung: **17.01.2018**
(21) Anmeldenummer: 13005910.8
(22) Anmeldetag: 18.12.2013
(51) Int. Cl.: G05B 19/042, G01R 31/327, G01R 31/02

(54) **Überwachungsvorrichtung, Sicherheitssystem und Verfahren zum Betreiben eines Sicherheitssystems**
Surveillance device, security system and method for operating a security system
Dispositif de surveillance, système de sécurité et procédé de fonctionnement d'un système de sécurité

(43) Veröffentlichungstag der Anmeldung: 24.06.2015
(73) Patentinhaber: Festo AG & Co. KG, 73734 Esslingen (DE)
(72) Erfinder: Kälberer, Roland, 73230 Kirchheim (DE); Hommel, Martin, 71229 Leonberg (DE); Leitner, Colin, 73240 Wendlingen (DE)
(74) Vertreter: Patentanwälte Magenbauer & Kollegen Partnerschaft mbB

(56) Entgegenhaltungen:
- EP-A1- 1 533 622
- EP-A2- 0 864 875
- DE-A1-102007 056 519
- DE-A1-102009 060 662
- US-B1- 6 198 612

## Beschreibung

Die Erfindung betrifft eine Überwachungsvorrichtung zur Überwachung von Sicherheitskomponenten, mit einer Überwachungselektronik, die mehrere Taktgeneratoren und Auswertemittel umfasst und an der wenigstens zwei zu überwachende Schnittstellen für eine elektrische Kopplung mit Sicherheitskomponenten ausgebildet sind, wobei jede der Schnittstellen wenigstens zwei Ausgangsanschlüsse und wenigstens zwei Eingangsanschlüsse umfasst, wobei ein erster Ausgangsanschluss und ein zweiter Ausgangsanschluss jeweils mit einem Taktgenerator verbunden ist, der für eine Bereitstellung von getakteten elektrischen Überwachungssignalen ausgebildet ist, wobei ein erster Eingangsanschluss und ein zweiter Eingangsanschluss mit den Auswertemitteln verbunden sind, die für eine Auswertung von eintreffenden Überwachungssignalen und für eine Ausgabe einer Fehlermeldung bei einem Ausbleiben von bereitgestellten Überwachungssignalen ausgebildet sind. Ferner betrifft die Erfindung ein Sicherheitssystem und ein Verfahren zum Betreiben eines Sicherheitssystems.

Aus der EP 0864875 A2 ist ein Verfahren zur Überprüfung einer Sicherheitsschaltung für elektrische Verbraucher, wie elektrische Maschinen, insbesondere Pressen oder dergleichen auf eventuelle Kurzschlüsse und / oder Fehler bekannt. Dabei weist die Sicherheitsschaltung zumindest einen Kontrollausgang und zumindest einen Eingang auf, wobei die Anzahl der Eingänge vorzugsweise von der Anzahl der Kontrollausgänge abweicht. Bei der Durchführung des Verfahrens ist vorgesehen, dass jeder Kontrollausgang ein Ausgangssignal abgibt, dass die Ausgangssignale den Eingängen als Eingangssignale zugeleitet werden und dass jedes Ausgangssignal zur Überprüfung eines möglichen Kurzschlusses genutzt wird. Ferner ist vorgesehen, dass mehrere, zumindest zwei Ausgangssignale parallel, d. h. im wesentlichen gleichzeitig während einer Phase hinsichtlich der Prüfung eines möglichen Kurzschlusses zwischen zwei Eingängen genutzt werden und dass die Gesamtzahl der Ausgangssignale in mehreren, nacheinander ablaufenden Phasen geprüft werden, wobei jede Phase der Prüfung mehrerer, zumindest zweier Ausgangssignale und / oder Eingangssignale dient.

Aus der DE 10 2007 056 519 A1 ist eine Auswerteeinheit bekannt, die einen ersten Eingang, einen zweiten Eingang, einen ersten Ausgang und einen zweiten Ausgang umfasst und der eine Signalverarbeitungseinheit zugeordnet ist, die mit dem ersten Eingang, dem zweiten Eingang, dem ersten Ausgang und dem zweiten Ausgang verbunden ist, wobei der erste Ausgang zumindest zeitweilig mit dem ersten Eingang und/oder dem zweiten Eingang verbindbar ist und/oder der zweite Ausgang zumindest zeitweilig mit dem zweiten Eingang und/oder dem ersten Eingang verbindbar ist und wobei die Signalverarbeitungseinheit zwei voneinander unterscheidbare Ausgangssignale erzeugt und das erste Ausgangssignal über den ersten Ausgang und/oder das zweite Ausgangssignal über den zweiten Ausgang ausgibt und die Signalverarbeitungseinheit durch Auswertung der zumindest zeitweilig an dem ersten Eingang und/oder dem zweiten Eingang anliegenden Eingangssignale erkennt, welcher Eingang mit welchem Ausgang verbunden ist.

Bei einem der Anmelderin bekannten, druckschriftlich nicht niedergelegten Stand der Technik ist vorgesehen, dass jedem der Ausgänge, die mit einem Taktgenerator verbunden sind, ein individueller Taktgenerator zugeordnet ist. Bei einem anderen der Anmelderin bekannten, druckschriftlich nicht niedergelegten Stand der Technik ist vorgesehen, das erste Ausgänge sämtlicher Schnittstellen mit einem ersten Taktgenerator und zweite Ausgänge sämtlicher Schnittstellen mit einem zweiten Taktgenerator verbunden sind.

Die Aufgabe der Erfindung besteht darin, eine Überwachungsvorrichtung, ein Sicherheitssystem und ein Verfahren zum Betreiben eines Sicherheitssystems anzugeben, bei denen unterschiedliche Fehlerarten ermittelt werden können.

Diese Aufgabe wird gemäß einem ersten Erfindungsaspekt für eine Überwachungsvorrichtung der eingangs genannten Art mit den Merkmalen des Anspruchs 1 gelöst. Hierbei ist vorgesehen, dass eine Anzahl von Taktgeneratoren größer als Zwei und kleiner als eine Anzahl sämtlicher Ausgangsanschlüsse der zu überwachenden Schnittstellen gewählt ist.

Dabei kann vorgesehen werden, an jeweils ersten Ausgangsanschlüssen von mehreren zu überwachenden Schnittstellen ein gemeinsames Taktsignal bereitzustellen. Um gegenüber dem Stand der Technik, der nur insgesamt zwei Taktgeneratoren für sämtliche Ausgangsanschlüsse der zu überwachenden Schnittstellen vorsieht, eine Verbesserung der Aussagekraft von Fehlermeldungen der Überwachungseinrichtung zu ermöglichen, ist erfindungsgemäß vorgesehen, an zweiten Ausgangsanschlüssen von wenigstens zwei Schnittstellen jeweils von separaten Taktgeneratoren bereitgestellte individuelle Taktsignale anzulegen.

Alternativ kann vorgesehen werden, dass an einer Gruppe von zu überwachenden Schnittstellen jeweils an den ersten Ausgangsanschlüssen ein erstes gemeinsames Taktsignal angelegt wird und dass an zweiten Ausgangsanschlüssen von Untergruppen dieser Gruppe von Schnittstellen jeweils innerhalb der Untergruppen gleiche, bezüglich der anderen Untergruppen jedoch unterschiedliche Taktsignale bereitgestellt werden.

Exemplarisch ist bei einer Anzahl von vier zu überwachenden Schnittstellen eine Anzahl von vier Taktgeneratoren ausreichen, um die Anzahl von insgesamt acht Ausgangsanschlüsse zu überwachen.

Ferner ist vorgesehen, dass der erste Ausgangsanschluss jeder zu überwachenden Schnittstelle mit einem individuell zugeordneten Taktgenerator verbunden ist und dass zweite Ausgangsanschlüsse von wenigstens zwei Schnittstellen mit einem gemeinsamen Taktgenerator verbunden sind. Dadurch kann an jeder der Schnittstellen an dem jeweils ersten Ausgangsanschluss ein individuelles Überwachungssignal bereitgestellt werden, während am zweiten Ausgangsanschluss der jeweiligen Schnittstelle ein Überwachungssignal bereitgestellt wird, das gegebenenfalls an wenigstens einer weiteren Schnittstelle oder mehreren weiteren Schnittstellen ebenfalls zur Verfügung gestellt wird. Durch eine derartige Bereitstellung von Überwachungssignalen an die entsprechenden Ausgangsanschlüsse kann, wie nachstehend bei der Erläuterung des Verfahrens ausgeführt wird, trotz einer Reduzierung der Anzahl von Taktgeneratoren verglichen mit demjenigen Stand der Technik, bei dem jedem Ausgangsanschluss ein Taktgenerator zugeordnet ist, ohne wesentlichen Verzicht auf Überprüfungsmöglichkeiten eine vereinfachte Aufbauweise für die Überwachungselektronik erzielt werden und gegenüber dem Stand der Technik, der nur zwei Taktgeneratoren für sämtliche Schnittstellen vorsieht, eine erhebliche Verbesserung der Überprüfungsmöglichkeiten erreicht werden.

Zweckmäßig ist es, wenn der weitere Taktgenerator mit sämtlichen zweiten Ausgangsanschlüssen der zu überwachenden Schnittstellen verbunden ist. Bei dieser Ausführungsform sind demnach für jede der zu überwachenden Schnittstellen ein individueller Taktgenerator und für sämtliche zu überwachenden Schnittstellen ein gemeinsamer Taktgenerator vorgesehen, so dass die Anzahl der Taktgeneratoren um den Wert eins größer als die Anzahl der zu überwachenden Schnittstellen, jedoch kleiner als die Anzahl der ersten und zweiten Ausgangsanschlüsse dieser Schnittstellen ist. Dies ermöglicht die angestrebte einfachere Aufbauweise für die Überwachungselektronik.

In weiterer Ausgestaltung der Erfindung ist vorgesehen, dass die Schnittstelle jeweils zwei Ausgangsanschlüsse und zwei Eingangsanschlüsse umfasst und ein erster Ausgangsanschluss mit dem individuell zugeordneten Taktgenerator verbunden ist und ein zweiter Ausgangsanschluss mit dem weiteren Taktgenerator verbunden ist und ein erster Eingangsanschluss mit den Auswertemitteln verbunden ist und ein zweiter Eingangsanschluss mit den Auswertemitteln verbunden ist. Bei den zu überwachenden Sicherheitskomponenten handelt es sich häufig um zweikanalige Schalter oder Sensoren, bei denen elektrische Signale oder Versorgungsspannungen über zwei parallele Leitungen ausgehend von dem ersten und zweiten Ausgangsanschluss der Schnittstelle bis zur Sicherheitskomponente geführt werden. Diese elektrischen Signale werden bei geschlossenen Schaltern oder bei entsprechender Beaufschlagung der Sensoren mit zu messenden Umgebungseinflüssen über zwei weitere, ebenfalls parallele Leitungen an die ersten und zweiten Eingangsanschlüsse der Schnittstelle bereitgestellt. Bei geöffneten Schaltern oder entsprechenden Umgebungseinflüssen findet zumindest auf einer der beiden parallelen Leitungen keine Bereitstellung des elektrischen Signals an die ersten und zweiten Eingangsanschlüsse der Schnittstelle statt. Die Aufgabe der Überwachungselektronik besteht darin, durch gezielte Beaufschlagung der jeweiligen Leitungen mit den Überwachungssignalen eine Ermittlung von Fehlfunktionen der Schalter oder Sensoren und/oder von Leitungsfehlern wie beispielsweise Kurzschlüssen zu ermöglichen.

Die Aufgabe der Erfindung wird gemäß einem zweiten Erfindungsaspekt durch ein Sicherheitssystem gelöst, wie es im Anspruch 4 angegeben ist. Dabei umfasst das Sicherheitssystem eine Überwachungsvorrichtung nach einem der Ansprüche 1 bis 3 und wenigstens eine Sicherheitskomponente, die Anschlussmittel zur Verbindung mit einer Schnittstelle der Überwachungsvorrichtung umfasst, wobei die Anschlussmittel wenigstens vier elektrische Leitungen umfassen, die jeweils paarweise zur elektrischen Ankopplung eines zu überwachenden Funktionselements, insbesondere eines Schalters oder eines Sensors, ausgebildet sind. Bei der Sicherheitskomponente kann es sich beispielsweise um einen zweikanaligen Sicherheitsschalter, beispielsweise eine Notausschalter, handeln. Bei einem derartigen Sicherheitsschalter sind zwei unabhängige Schaltkontakte vorgesehen, die mit jeweils zugeordneten elektrischen Leitungen verbunden sind, wobei die elektrischen Leitungen an der Schnittstelle der Überwachungsvorrichtung angeschlossen sind. Eine derartige Sicherheitskomponente kann mit der erfindungsgemäßen Überwachungsvorrichtung sowohl im Hinblick auf die Funktion der Schaltkontakte als auch im Hinblick auf die Funktion der elektrischen Leitungen geprüft werden. Exemplarisch umfasst das Sicherheitssystem wenigstens drei Sicherheitskomponenten und die Überwachungsvorrichtung ist beispielsweise für den Anschluss dieser wenigstens drei Sicherheitskomponenten ausgelegt.

Die Aufgabe der Erfindung wird gemäß einem dritten Erfindungsaspekt durch ein im Anspruch 5 angegebenes Verfahren zum Betreiben eines Sicherheitssystems gelöst. Hierbei ist vorgesehen, dass an Schnittstellen einer Überwachungsvorrichtung jeweils Sicherheitskomponenten angeschlossen sind und dass die Überwachungsvorrichtung wenigstens zwei Taktgeneratoren umfasst, die zur Bereitstellung von Überwachungssignalen an Ausgangsanschlüsse der Schnittstellenausgebildet sind, und mit Auswertemitteln zur Überwachung von Eingangsanschlüssen der Schnittstellen auf ein Eintreffen von ausgesendeten Überwachungssignalen, wobei die Taktgeneratoren derart betrieben werden, dass in wiederkehrendenden Zeitabschnitten die von den wenigstens zwei Taktgeneratoren an die Ausgangsanschlüsse bereitgestellten Überwachungssignale einen Signalpegel unterhalb einer vorgebbaren Ansprechschwelle der Auswertemittel aufweisen. Somit kann in den wiederkehrenden Zeitabschnitten, in denen die an die Ausgangsanschlüsse bereitgestellten Überwachungssignale einen Signalpegel unterhalb einer vorgebbaren Ansprechschwelle der Auswertemittel aufweisen, geprüft werden, ob unerwünschte Verbindungen der überwachten Sicherheitskomponenten eventuell mit elektrischen Versorgungsleitungen kurzgeschlossen sind. Dieses Verfahren kann in vorteilhafter Weise sowohl für das erfindungsgemäße Sicherheitssystem als auch für Sicherheitssysteme eingesetzt werden, die mit Überwachungsvorrichtungen nach dem Stand der Technik ausgerüstet sind. Der erfindungsgemäße unterschied gegenüber bekannten Verfahren liegt darin, dass bei der Prüfung der angeschlossenen Sicherheitskomponenten in den Zeitabschnitten, in denen die an die Ausgangsanschlüsse bereitgestellten Überwachungssignale einen Signalpegel unterhalb einer vorgebbaren Ansprechschwelle der Auswertemittel aufweisen, auch keine Erfassung von Schaltvorgängen der angeschlossenen Sicherheitskomponenten stattfinden kann. Da jedoch die Zeitabschnitte, in denen die an die Ausgangsanschlüsse bereitgestellten Überwachungssignale einen Signalpegel unterhalb einer vorgebbaren Ansprechschwelle der Auswertemittel aufweisen sehr kurz gewählt werden können, tritt hierdurch aus praktischer Sicht keine Beeinträchtigung der Sicherheitsfunktion ein, die durch die Sicherheitskomponenten gewährleistet werden soll. Exemplarisch kann eine Dauer der Zeitabschnitte, in denen die an die Ausgangsanschlüsse bereitgestellten Überwachungssignale einen Signalpegel unterhalb einer vorgebbaren Ansprechschwelle der Auswertemittel aufweisen, im Bereich von wenigen Millisekunden gewählt werden.

Ferner ist vorgesehen, dass jedem ersten Ausgangsanschluss der zu überwachenden Schnittstellen ein Taktgenerator zur Bereitstellung eines individuellen Überwachungssignals zugeordnet ist und dass wenigstens ein Taktgenerator mit zweiten Ausgangsanschlüssen von wenigstens zwei Schnittstellen verbunden ist, um ein gemeinsames Überwachungssignal an diese zweiten Ausgangsanschlüsse bereitzustellen, wobei zu einem vorgebbaren ersten Zeitpunkt alle individuellen Überwachungssignale und wenigstens ein gemeinsames Überwachungssignal an die ersten und zweiten Ausgangsanschlüsse bereitgestellt werden.

Dadurch kann zum ersten Zeitpunkt eine synchrone Prüfung aller angeschlossenen Sicherheitskomponenten dahingehend vorgenommen werden, dass festgestellt wird, ob die bereitgestellten Überwachungssignale erwartungsgemäß an den zugeordneten Eingangsanschlüssen der Schnittstellen eintreffen oder ob dies nicht der Fall ist. Wenn es sich bei den Sicherheitskomponenten beispielsweise um Notausschalter oder Türkontaktschalter handelt, die bei einem normalen Betrieb einer mit dem Sicherheitssystem ausgerüsteten Bearbeitungsmaschine geschlossen sind, kann in einem Prüfzyklus festgestellt werden, ob die Sicherheitskomponenten den erwarteten geschlossenen Zustand aufweisen oder ob Fehler aufgetreten sind bzw. ob eine Abweichung vom normalen Betrieb, wie sie beispielsweise durch Betätigung eines Notausschalters oder durch Öffnen einer Tür, die mit einem Türkontaktschalter ausgerüstet ist, auftreten kann, vorliegt. Sofern das Vorliegen eines Fehlers oder eine Abweichung vom normalen Betrieb festgestellt wird, kann eine Fehlermeldung ausgegeben werden, die insbesondere zu einem Nothalt oder Notaus für die überwachte Bearbeitungsmaschine führt.

In weiterer Ausgestaltung des Verfahrens ist vorgesehen, dass die individuellen Überwachungssignale und/oder das wenigstens eine gemeinsame Überwachungssignal zyklisch wiederkehrend an die jeweiligen Ausgangsanschlüsse bereitgestellt werden. Durch eine zyklisch wiederkehrende Bereitstellung und eine zwischenzeitliche Abschaltung der jeweiligen individuellen Überwachungssignale kann festgestellt werden, ob andere individuelle Überwachungssignale auch an Eingangsanschlüssen von Schnittstellen auftreten, denen diese individuellen Überwachungssignale nicht zugeordnet sind. Daraus kann der Schluss gezogen werden, dass die ordnungsgemäß mit dem jeweiligen individuellen und/oder gemeinsamen Überwachungssignal beaufschlagte Sicherheitskomponente fehlerhaft ist und das individuelle Überwachungssignal dieser Sicherheitskomponente in fehlerhafter Weise an wenigstens einem anderen Eingangsanschluss vorliegt.

In weiterer Ausgestaltung des Verfahrens ist vorgesehen, dass die Taktgeneratoren für die Bereitstellung der Überwachungssignale zeitversetzt zueinander aktiviert und deaktiviert werden. Hierdurch können zu unterschiedlichen Zeitpunkten unterschiedliche Kombinationen von individuellen und gemeinsamen Überwachungssignalen an die angeschlossenen Sicherheitskomponenten bereitgestellt werden und durch die zugeordneten Auswertemittel auf ein Auftreten von Fehlern oder Abweichungen vom normalen Betrieb untersucht werden, wobei in Abhängigkeit von den jeweils aktiven Taktgeneratoren und den hieraus resultierenden Überwachungssignalen unterschiedliche Rückschlüsse auf ein Vorliegen von Fehlern gezogen werden können.

In weiterer Ausgestaltung des Verfahrens ist vorgesehen, dass zu einem vorgebbaren zweiten Zeitpunkt an den Schnittstellen kein individuelles Überwachungssignal anliegt. Hierdurch können Fehler in elektrischen Leitungen der jeweiligen Sicherheitskomponenten ermittelt werden, die mit einem gemeinsamen Überwachungssignal beaufschlagt werden.

In weiterer Ausgestaltung des Verfahrens ist vorgesehen, dass zu einem vorgebbaren dritten Zeitpunkt an den jeweiligen Schnittstellen kein gemeinsames Überwachungssignal anliegt. Hierdurch kann in Abhängigkeit davon, welches der individuellen Überwachungssignale zu diesem Zeitpunkt aktiv ist, ein Rückschluss darauf gezogen werden, ob die wenigstens eine mit dem individuellen Überwachungssignal beaufschlagte elektrische Leitung der jeweiligen Sicherheitskomponente fehlerhaft ist.

In weiterer Ausgestaltung des Verfahrens ist vorgesehen, dass die Taktgeneratoren derart betrieben werden, dass zu einem vorgebbaren vierten Zeitpunkt an wenigstens einer Schnittstelle kein individuelles Überwachungssignal und kein gemeinsames Überwachungssignal bereitgestellt werden. Hierdurch kann beispielsweise ein Kurzschluss gegenüber einer Versorgungsspannung ermittelt werden, sofern zum vorgegebenen zweiten Zeitpunkt auch kein gemeinsames Überwachungssignal in an den Schnittstellen bereitgestellt wird und dennoch an zumindest einem der Anschlüsse ein elektrisches Signal anliegt.

In weiterer Ausgestaltung der Erfindung ist vorgesehen, dass zu einem vorgebbaren Zeitpunkt ausschließlich an einer einzigen Schnittstelle ein individuelles Überwachungssignal anliegt. Hierdurch kann ermittelt werden, ob in der elektrischen Leitung der zugeordneten Sicherheitskomponente, die mit diesem individuellen Überwachungssignal beaufschlagt wird, ein Fehler vorliegt.

In weiterer Ausgestaltung der Erfindung ist vorgesehen, dass Zykluszeiten für die Bereitstellung der Überwachungssignale abweichend voneinander gewählt sind. Hierdurch können unterschiedliche zeitliche Überschneidungen zwischen dem einzelnen individuellen und/oder gemeinsamen Überwachungssignalen erreicht werden, um beispielsweise eine elektrische Versorgung eines als Sicherheitskomponente ausgebildeten Sensors nur kurzfristig für Überwachungszwecke zu unterbrechen, um dessen Messergebnisse nur geringfügig oder gar nicht zu beeinflussen, während beispielsweise eine Überwachung einer als Notausschalter ausgebildeten Sicherheitskomponente ohne eine Gefährdung der Funktionsweise dieser Sicherheitskomponente auch mit längerfristig deaktivierten Überwachungssignalen vorgenommen werden kann.

In weiterer Ausgestaltung der Erfindung ist vorgesehen, dass wenigstens ein Taktgenerator dauerhaft aktiviert wird und das hierdurch bereitgestellte Überwachungssignal zur elektrischen Versorgung der Sicherheitskomponente dient.

Vorteilhafte Ausführungsformen der Erfindung sind in der Zeichnung dargestellt. Hierbei zeigt:
- Figur 1: eine erste Ausführungsform eines Sicherheitssystems mit einer Überwachungsvorrichtung und daran angeschlossenen, als Sensoren ausgebildeten Sicherheitskomponenten,
- Figur 2: eine zweite Ausführungsform eines Sicherheitssystems, bei dem die Sicherheitskomponenten als Trittschaltmatten ausgebildet sind,
- Figur 3: eine dritte Ausführungsform eines Sicherheitssystems, bei dem die Sicherheitskomponenten als zweikanalige Schalter ausgebildet sind,
- Figur 4: ein erstes Signalverlaufsdiagramm für das Sicherheitssystem gemäß der Figur 3,
- Figur 5: ein zweites Signalverlaufsdiagramm für das Sicherheitssystem gemäß der Figur 3,
- Figur 6: ein drittes Signalverlaufsdiagramm für das Sicherheitssystem gemäß der Figur 3,
- Figur 7: ein viertes Signalverlaufsdiagramm für das Sicherheitssystem gemäß der Figur 3,
- Figur 8: ein fünfte Signalverlaufsdiagramm für das Sicherheitssystem gemäß der Figur 3,
- Figur 9: ein sechstes Signalverlaufsdiagramm für das Sicherheitssystem gemäß der Figur 3,
- Figur 10: ein siebtes Signalverlaufsdiagramm für das Sicherheitssystem gemäß der Figur 3 und
- Figur 11: ein achtes Signalverlaufsdiagramm für das Sicherheitssystem gemäß der Figur 3.

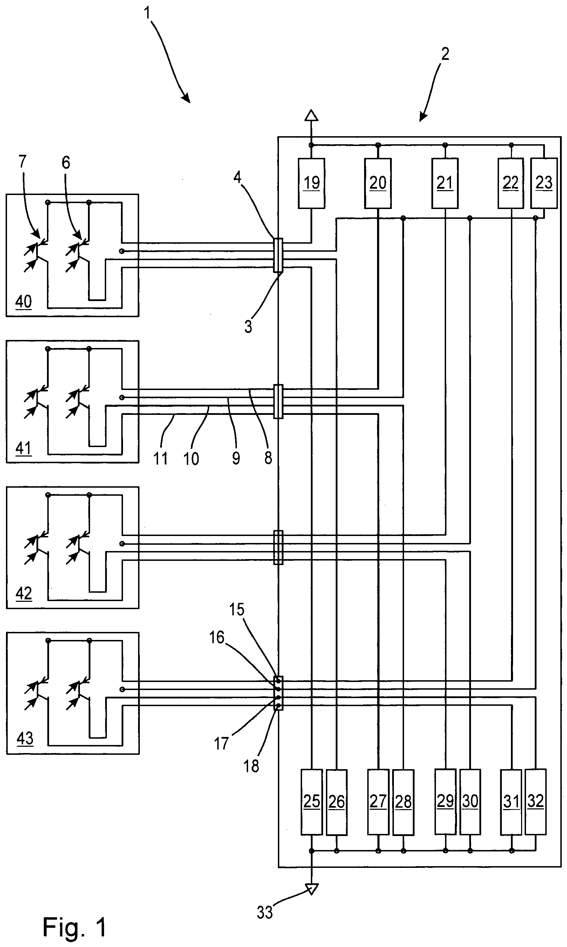

In der Figur 1 ist ein Sicherheitssystem 1 mit einer Überwachungsvorrichtung 2 dargestellt, wie es beispielsweise an einer nicht näher dargestellten Bearbeitungsmaschine, die ein Gefährdungspotenzial für Menschen und/oder Gegenstände aufweist, eingesetzt werden kann. Bei derartigen Bearbeitungsmaschinen kann es sich beispielsweise um Industrieroboter, Sägen, Fräsmaschinen, Drehmaschinen oder um andere Einrichtungen, handeln bei denen kraftbetätigte Komponenten bewegt und/oder schnell laufende Werkzeuge betrieben werden. Für derartige Bearbeitungsmaschinen ist eine Vielzahl von sicherheitstechnischen Einrichtungen vorgeschrieben, mit deren Hilde die Gefahren für Menschen und/oder Gegenstände auf ein Minimum reduzieren werden sollen. Diese sicherheitstechnischen Einrichtungen umfassen typischerweise auch Sicherheitssysteme 1, die dazu ausgelegt sind, vorgegebene Bereiche an der bzw. um die Bearbeitungsmaschine zu sichern, indem beispielsweise Abdeckungen, Türen, Bodenabschnitte und/oder Raumvolumina mit Türöffnungsschaltern, Trittschaltmatten oder Lichtgittern versehen werden. Mit derartigen Einrichtungen soll insbesondere ein unbefugtes Eindringen in zu sichernde Bereiche vermieden werden. Im Fall eines solchen Eindringens soll ein Nothalt oder eine Notabschaltung der Bearbeitungsmaschine herbeigeführt werden, um eine Gefährdung für einen Bediener und für die Bearbeitungsmaschine zu minimieren.

Hierzu umfasst das in der Figur 1 dargestellte Sicherheitssystem 1 mehrere an Schnittstellen 3 der Überwachungsvorrichtung 2 mit Anschlussmitteln 4 angeschlossene, exemplarisch jeweils gleichartig ausgebildete Sicherheitskomponenten 40, 41, 42, 43. Exemplarisch umfassen die Sicherheitskomponenten 40, 41, 42, 43 jeweils zwei, beispielhaft als Phototransistoren ausgebildete, lichtempfindliche elektronische Schalter 7, 8, die als Bestandteil eines nicht näher dargestellten Lichtgitters für den Empfang von Lichtstrahlen ausgebildet sind. Beispielhaft durchsetzen die Lichtstrahlen ihrerseits in gitterartiger Anordnung eine nicht dargestellte Eingriffsfläche und werden bei einem Eingreifen durch die Eingriffsfläche zumindest teilweise unterbrochen. Eine solche Unterbrechung kann mit Hilfe der Schalter 7, 8 detektiert werden, um daraufhin einen Nothalt oder eine Notabschaltung für die Bearbeitungsmaschine auszulösen. Um einen zuverlässigen Betrieb des Sicherheitssystems 1 zu gewährleisten, müssen die Sicherheitskomponenten 40, 41, 42, 43 während des Betriebs fortlaufend überwacht werden, was mit Hilfe der Überwachungsvorrichtung 2 erfolgt. Hierbei ist insbesondere vorgesehen, in vorgebbaren zeitlichen Abständen zu überprüfen, ob die elektrischen Verbindungen zwischen der Überwachungsvorrichtung 2 und den Sicherheitskomponenten 40, 41, 42, 43 störungsfrei sind. Ansonsten könnte eine Übertragung von Signalen von den Sicherheitskomponenten 40, 41, 42, 43 an die Überwachungsvorrichtung 2 sowie gegebenenfalls an eine mit der Überwachungsvorrichtung 2 gekoppelte, nicht dargestellte Maschinensteuerung, insbesondere eine speicherprogrammierbare Steuerung (SPS), beispielsweise durch Beschädigung der elektrischen Leitungen, insbesondere durch elektrischen Kurzschluss oder Unterbrechung, in Frage gestellt sein.

Exemplarisch ist vorgesehen, dass die Anschlussmittel 4 der zu überwachenden Sicherheitskomponenten 40, 41, 42, 43 jeweils vier elektrische Leitungen 8, 9, 10 und 11 umfassen. Dabei ist die erste elektrische Leitung 8 an einem ersten Anschluss 15 der Schnittstelle 4 angeschlossen, der auch als erster Ausgangsanschluss bezeichnet wird, da dort ein erstes Überwachungssignal von der Überwachungsvorrichtung 2 bereitgestellt wird. Die zweite elektrische Leitung 9 ist an einem zweiten Anschluss 16 der Schnittstelle 4 angeschlossen, der auch als zweiter Ausgangsanschluss bezeichnet wird, da dort ein zweites Überwachungssignal von der Überwachungsvorrichtung 2 bereitgestellt wird. Die dritte elektrische Leitung 10 ist an einem dritten Anschluss 17 der Schnittstelle 4 angeschlossen, der auch als erster Eingangsanschluss bezeichnet wird, da dort ein durch die jeweils angeschlossene Sicherheitskomponente 40, 41, 42, 43 übertragenes erstes Überwachungssignal bereitgestellt wird und die vierte elektrische Leitung 11 ist an einem vierten Anschluss 18 der Schnittstelle 4 angeschlossen, der auch als zweiter Eingangsanschluss bezeichnet wird, da dort ein durch die jeweils angeschlossene Sicherheitskomponente 40, 41, 42, 43 übertragenes zweites Überwachungssignal bereitgestellt wird.

Weiterhin ist vorgesehen, dass exemplarisch mit der jeweils ersten elektrischen Leitung 8 der jeweiligen Sicherheitskomponente 40, 41, 42, 43 ein dieser Sicherheitskomponente 40, 41, 42, 43 am jeweils ersten Ausgangsanschluss 15 individuell zugeordneter Taktgenerator 19, 20, 21, 22 verbunden ist. Beispielhaft ist die erste elektrische Leitung 8 ihrerseits jeweils mit beiden elektronischen Schaltern 6, 7 verbunden und wird von dort als Leitung 10 bzw. 11 bis zum ersten bzw. zweiten Eingangsanschluss 17, 18 weitergeführt.

Ferner ist exemplarisch vorgesehen, dass jeweils die zweite elektrische Leitung 9 jeder der Sicherheitskomponenten 40, 41, 42, 43 über den jeweiligen zweiten Ausgangsanschluss 16 der zugeordneten Schnittstelle 3 mit einem gemeinsamen Taktgenerator 23 verbunden ist. Dabei kann die vom gemeinsamen Taktgenerator 23, insbesondere als Dauersignal bereitgestellte, elektrische Energie zur Versorgung der beiden elektronischen Schalter 6, 7 in den jeweiligen Sicherheitskomponenten 40, 41, 42, 43 vorgesehen.

Der elektronische Schalter 6 ist bei jeder der Sicherheitskomponenten 40, 41, 42, 43 mit der elektrischen Leitung 11 verbunden. Der elektronische Schalter 7 ist bei jeder der Sicherheitskomponenten 40, 41, 42, 43 mit der elektrischen Leitung 10 verbunden. Jede der elektrischen Leitungen 10, 11 der jeweiligen elektronischen Schalter 6 ,7 ist über den jeweils zugeordneten Eingangsanschluss 17, 18 mit einer Auswerteschaltung 25 bis 32 elektrisch verbunden, die zur Ermittlung eines Stromflusses durch die jeweilige Leitung 10, 11 ausgebildet sind. Die Auswerteschaltungen 25 bis 32 sind jeweils zur Ausgabe eines Ausgangssignals ausgebildet, das nur für den Fall ausgegeben wird, dass ein Stromfluss durch die jeweilige Leitung 10, 11 über einen vorgebbaren Schwellwert liegt. Die Ausgangssignale der jeweiligen Auswerteschaltungen 25 bis 32 werden an einen gemeinsamen Signalanschluss 33 bereitgestellt, der mit einer nicht dargestellten Maschinensteuerung verbunden ist, die dazu eingerichtet ist, das Ausgangssignal auf das Vorliegen von unerwarteten Signalverläufen auszuwerten und gegebenenfalls eine Abschaltung der Bearbeitungsmaschine vorzunehmen.

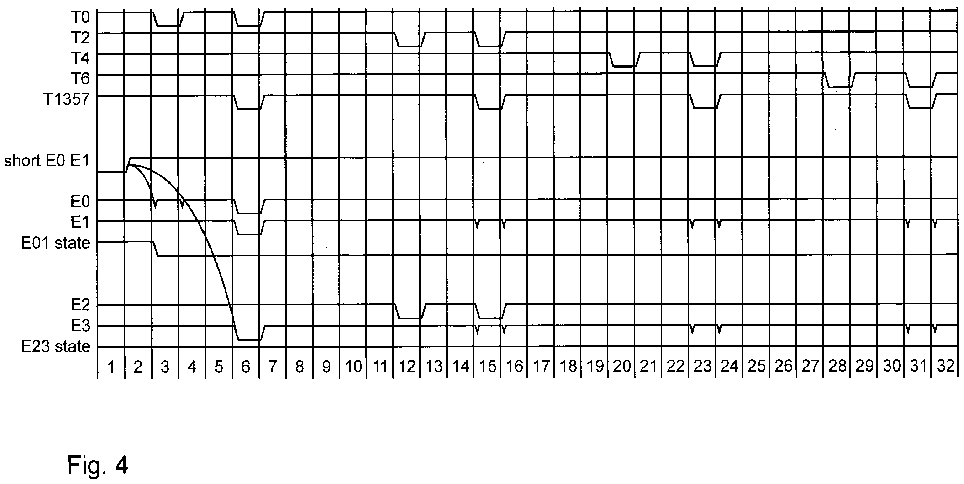

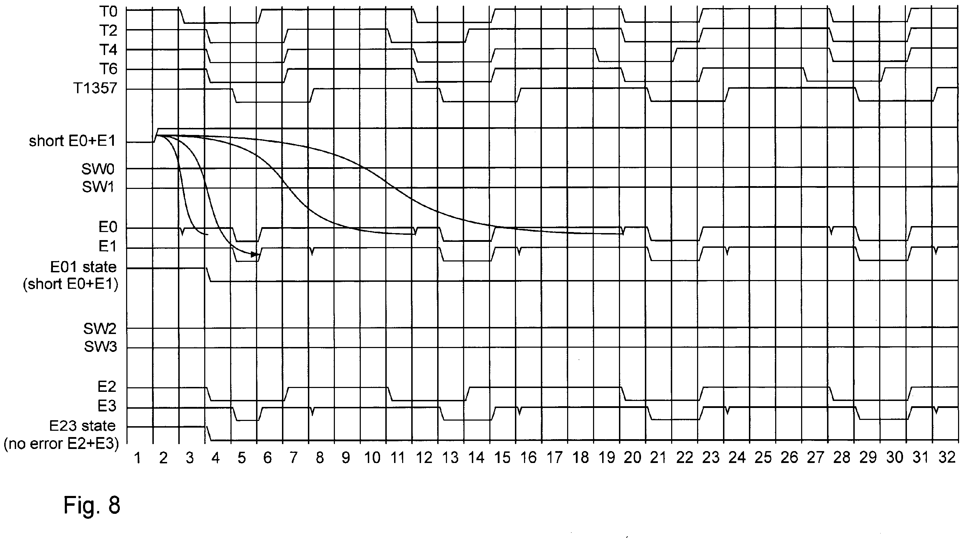

Exemplarisch kann vorgesehen sein, dass die Taktgeneratoren 19 bis 22 derart durch nicht dargestellte interne Kommunikationsmittel oder durch eine geeignete Ansteuerung von außen, insbesondere durch die Maschinensteuerung, derart betrieben werden, dass sich am Signalanschluss 33 bei korrekter Funktion der überwachten Sicherheitskomponenten 40, 41, 42 und 43 ein vorgegebenes Signalmuster ergibt. Demgegenüber treten Abweichungen vom vorgegebenen Signalmuster am Signalanschluss 33 auf, sofern in den elektrischen Leitungen 8 bis 10 und/oder in den überwachten Sicherheitskomponenten 40, 41, 42 und 43 Fehlfunktionen auftreten. Die Auswertung derartiger Signalmuster wird nachstehend im Zusammenhang mit den Figuren 4 bis 11 näher erläutert.

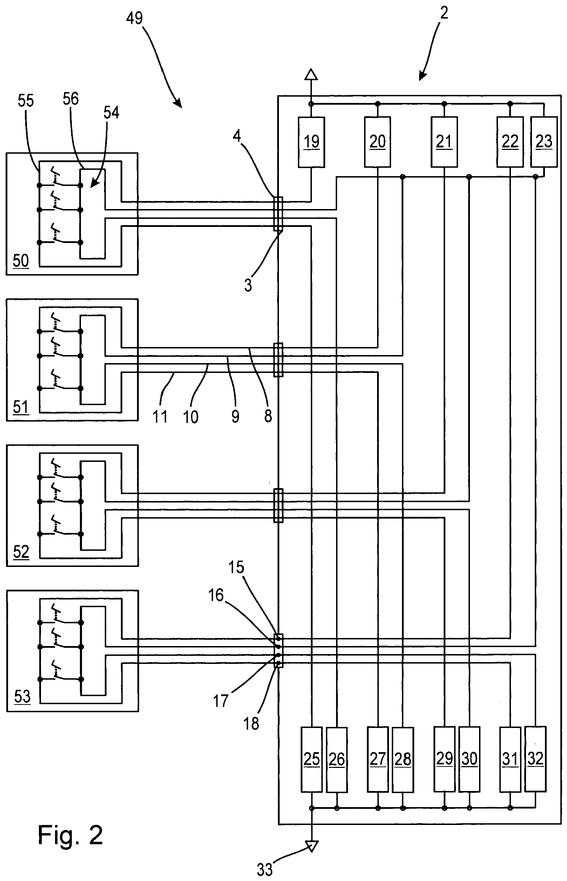

Bei der in Figur 2 dargestellten Ausführungsform eines Sicherheitssystems 49 umfassen die Sicherheitskomponenten 50, 51, 52 und 53 jeweils mehrpolige Schalter 54, wie sie beispielsweise bei Trittschaltmatten vorgesehen sein können. Trittschaltmatten dienen zur Überwachung von Bodenbereichen und sind derart aufgebaut, dass im Fall eines Betretens der Trittschaltmatte ein elektrischer Kurzschluss zwischen zwei Leitungen hergestellt wird, so dass ein Strom fließen kann, der als Schaltsignal interpretiert werden kann. Im Normalfall, also ohne dass ein Benutzer die Trittschaltmatte betreten hat, liegt kein Kurzschluss vor, so dass auch kein Stromfluss zwischen den Leitungen stattfindet. Um dennoch feststellen zu können, ob die Leitungen intakt sind und bei Betreten der Trittschaltmatte ein dadurch ausgelöstes Schaltsignal übertragen werden kann, sind die jeweiligen Leitungen durch die Trittschaltmatte hindurchgeschleift und können somit auf ihre Leitfähigkeit hin überprüft werden. Exemplarisch ist vorgesehen, dass die Sicherheitskomponenten 50, 51, 52 und 53 an eine Überwachungsvorrichtung 2 angeschlossen sind, wie sie bereits im Zusammenhang mit der Figur 1 beschrieben wurde. Bei der in Figur 2 dargestellten zweiten Ausführungsform eines Sicherheitssystems 49 ist jeweils die erste Leitung 8 als Anfang einer ersten Leiterschleife 55 ausgebildet, während die zweite Leitung 9 als Anfang einer zweiten Leiterschleife 56 ausgebildet ist. Ferner ist die dritte Leitung 10 als Ende der ersten Leiterschleife 55 ausgebildet und die vierte Leitung 11 ist als Ende der zweiten Leiterschleife 56 ausgebildet.

Die Nutzung der Überwachungsvorrichtung 2 ist bei der Ausführungsform des Sicherheitssystems 49 so vorgesehen, dass die Taktgeneratoren 19 bis 23 in vorgegebenen, insbesondere zyklisch wiederkehrenden, zeitlichen Abständen die jeweiligen Leitungen 8 bis 11 mit elektrischer Energie versorgen und die Auswerteschaltungen 25 bis 32 einen Stromfluss in den jeweiligen Leitungen 8 bis 11 ermitteln. Ferner ist vorgesehen, dass zumindest zeitweilig alle Taktgeneratoren 19 bis 23 kein Überwachungssignal mit einem Signalpegel ausgeben, der oberhalb einer von den zugeordneten Auswerteeinrichtungen detektierbaren Ansprechschwelle der Auswertemittel 25 bis 32 liegt, so dass in diesem Zeitabschnitt bei korrekter Funktion aller Komponenten des Sicherheitssystems 49 kein Signal am Signalanschluss 33 vorliegen sollte. Sofern dies doch der Fall ist, muss von einer Fehlfunktion im Sicherheitssystem 49 ausgegangen werden.

Diese Vorgehensweise kann sogar auf ein Sicherheitssystem mit Überwachungsvorrichtungen nach dem Stand der Technik, insbesondere auch auf ein Sicherheitssystem mit Überwachungsvorrichtungen, die genau zwei Taktgeneratoren für alle zu überwachenden Schnittstellen aufweisen, angewandt werden. Dabei kann auch hier in dem Zeitabschnitt, in dem keiner der Taktgeneratoren ein von den Auswertemitteln detektierbares Überwachungssignal ausgibt, auf ein Vorhandensein von Kurzschlüssen einzelner Leitungen gegenüber einer Versorgungspannung geschlossen werden.

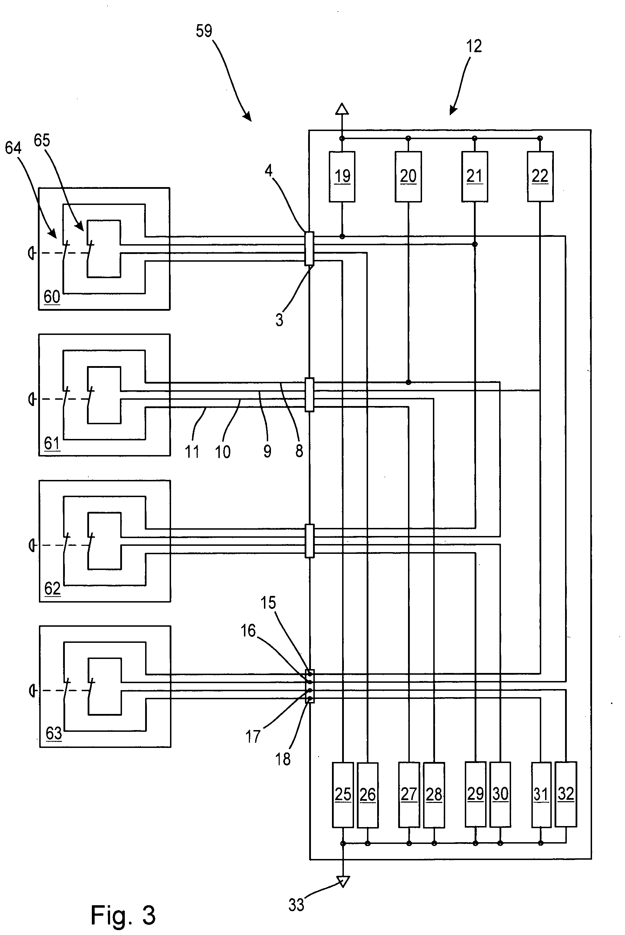

Bei der in Figur 3 dargestellten Ausführungsform eines Sicherheitssystems 59 sind anstelle der gemäß Figur 2 vorgesehenen Trittschaltmatten die Sicherheitskomponenten 60, 61, 62 und 63 als zweipolige, mechanisch gekoppelte Schalter ausgebildet, wie dies beispielsweise bei Notausschaltern der Fall ist. Ferner ist eine zweite Ausführungsform einer Überwachungsvorrichtung 12 vorgesehen, die sich von der ersten Ausführungsform einer Überwachungsvorrichtung 2 dadurch unterscheidet, dass jedem Taktgenerator 19, 20, 21, 22 jeweils zwei Ausgangsanschlüsse 16, 16 zugeordnet sind. Exemplarisch ist jeder der Schalter 64, 65 der jeweiligen Sicherheitskomponente 60, 61, 62 und 63 in einer individuellen Leitschleife 67, 68 angeordnet, die dementsprechend vom jeweiligen Schalter 64, 65 unterbrochen werden kann. Am Anfang der jeweiligen Leiterschleife 67 bzw. 68 sind die Leitungen 8 bzw. 9 jeweils an einem der Ausgangsanschlüsse 15, 16 der Überwachungsvorrichtung 2 angeschlossen. Am Ende der jeweiligen Leiterschleife 67 bzw. 68 sind die Leitungen 10 bzw. 11 jeweils an einem der Eingangsanschlüsse 17, 18 der Überwachungsvorrichtung 2 angeschlossen. Vorzugsweise sind die Sicherheitskomponenten 60, 61, 62 und 63 als normal geschlossene Schalter ausgebildet, so dass im Betriebs- oder Normalzustand stets ein Stromfluss durch die jeweils angeschlossenen Leitungen 8 bis 11 ermöglicht wird. Die Überwachungsvorrichtung 2 stellt am Signalanschluss 33 ein von den Schaltstellungen der Schalter 64, 65 und den Überwachungssignalen der Taktgeneratoren 19 bis 23 abhängiges Ausgangssignal zur Verfügung.

Exemplarisch ist vorgesehen, dass die Leitungen 9 und 10 der ersten Sicherheitskomponente 60 mit den Taktgeneratoren 19 und 21 verbunden sind. Ferner ist vorgesehen, dass die Leitungen 9 und 10 der zweiten Sicherheitskomponente 61 mit den Taktgeneratoren 20 und 22 verbunden sind. Ferner ist vorgesehen, dass die Leitungen 9 und 10 der dritten Sicherheitskomponente 62 mit den Taktgeneratoren 20 und 21 verbunden sind. Ferner ist vorgesehen, dass die Leitungen 9 und 10 der vierten Sicherheitskomponente 63 mit den Taktgeneratoren 19 und 22 verbunden sind.

Die nachstehend beschriebenen Signalverläufe von Überwachungssignalen, wie sie in den Figuren 4 bis 11 dargestellt sind, können in ähnlicher Form bei jedem der in den Figuren 1 bis 3 dargestellten Ausführungsformen von Sicherheitssystemen 1, 49 und 59 auftreten und werden nunmehr exemplarisch anhand des Sicherheitssystems 49 gemäß der Figur 2 näher erläutert.

Im Signalverlaufsdiagramm gemäß der Figur 4 ist vorgesehen, dass sämtliche Signalpegel oder Takte T0, T2, T4 und T6 der individuell zugeordneten Taktgeneratoren 19 bis 22 zeitlich versetzt zueinander vorliegende logische "Low"-Signal liefern, wie dies beispielsweise für den Takt T0 in den Arbeitstakten 3 und 6 der Fall ist. Somit wird gewährleistet, dass zu keinem Zeitpunkt zwei dieser Taktgeneratoren 19 bis 22 ein logisches "Low"-Signal liefern. Vielmehr stellen stets alle individuell zugeordneten Taktgeneratoren 19 bis 22 bis auf jeweils einen Taktgenerator 19 bis 22 ein logisches "High"-Signal bereit. Ferner ist bei allen dieser Taktgeneratoren 19 bis 22 exemplarisch eine Abfolge von zwei logischen "Low"-Signalen mit jeweils einer Dauer eines Arbeitsakts und einem zeitlichen Abstand von zwei Arbeitstakten vorgesehen. Der Signalpegel T1357 des gemeinsamen Taktgenerators 23 hat jeweils synchron mit dem zweiten logischen "Low"-Signal jeweils eines der individuellen Taktgeneratoren 19 bis 22 ebenfalls ein logisches "Low"-Signal, das ebenfalls einen Arbeitstakt andauert.

Aus Gründen der Vereinfachung werden nur die an den jeweils zugeordneten Auswerteschaltungen 25 bis 28 eintreffenden Takte oder Signalpegel in der Figur 4 dargestellt und sind mit den Bezeichnungen E0, E1, E2 und E3 versehen. Die an den übrigen Auswerteschaltungen 29 bis 32 eintreffenden Signalpegel bleiben für die nachfolgenden Betrachtungen unberücksichtigt. Ferner ist in der Figur 4 mit der Bezeichnung "short E0 E1" ein Auftreten eines Kurzschlusses zwischen den Leitungen 10 und 11 der Sicherheitskomponente 50 angedeutet.

Durch die vorstehende Abfolge von logischen "High"- und "Low"-Signalpegeln kann im jeweils ersten Arbeitstakt jedes Taktgenerators 19 bis 22, in dem ein logisches "Low"-Signal auftritt, geprüft werden, ob Signale anderer Taktgeneratoren auf die jeweilige Leitung eingekoppelt werden. Sofern an der jeweils zugeordneten Auswerteschaltung 25 bis 28 anstelle eines zu erwartenden logischen "Low"-Signals ein logisches "High"-Signal eintrifft, wird dies von den Auswerteschaltungen 25 bis 28 als Fehler detektiert. Im jeweils zweiten Arbeitstakt jedes individuellen Taktgenerators 19 bis 22, in dem erneut ein logisches "Low"-Signal ausgegeben wird, stellt auch der gemeinsame Taktgenerator 23 einen Signalpegel T1357 mit logischem "Low"-Signal zur Verfügung. Damit kann zu diesem Zeitpunkt ermittelt werden, ob ein im ersten Arbeitstakt aufgrund eines erwarteten aber nicht eingetretenen logischen "Low"-Pegels von der jeweiligen Auswerteschaltung ermittelter Fehler auch im zweiten Arbeitstakt mit logischem "Low"-Pegel vorliegt.

Exemplarisch äußert sich ein ab dem Arbeitstakt 2 vorliegender Kurzschluss (short E0 E1 auf logischem "High"-Pegel) zwischen den Leitungen 8 und 9 oder 10 und 11 der ersten Sicherheitskomponente 50 als unerwartetes "High"-Signal im Ausgangssignal E0 der ersten Überwachungsschaltung 25, da zu diesem Zeitpunkt eigentlich kein "High"-Signal an der zugeordneten Auswerteschaltung 25 vorliegen sollte. Das unerwartete Vorliegen eines "High"-Signals führt dazu, dass ein Signalpegel für ein Ausgangsignal am Signalanschluss 33 von einem logischen "High"-Signal auf ein logisches "Low"-Signal (E01 state) gesenkt wird. Für die Diagnose des Kurzschlusses ist somit in diesem Fehlerfall die Auswertung des individuellen Taktes ausreichend.

Im Arbeitstakt 6 kann dennoch die Kurzschlussprüfung gegenüber der Leitung, die durch den gemeinsamen Taktgenerator 23 mit einem Signalpegel beaufschlagt wird, unbeeinflusst von dem bereits festgestellten Kurzschluss durchgeführt werden, wodurch die Fehlersuche vereinfacht wird. Exemplarisch tritt im Arbeitstakt 6 trotz des bereits detektierten Kurzschlusses eine Absenkung des Ausgangssignals E3 auf einen logischen "Low"-Signalpegel ein. Hieraus kann der Schluss gezogen werden, dass ein Kurzschluss zwischen der mit dem individuellen Taktgenerator 19 verbundenen Leitung und der mit dem gemeinsamen Taktgenerator 23 verbundenen Leitung vorliegt.

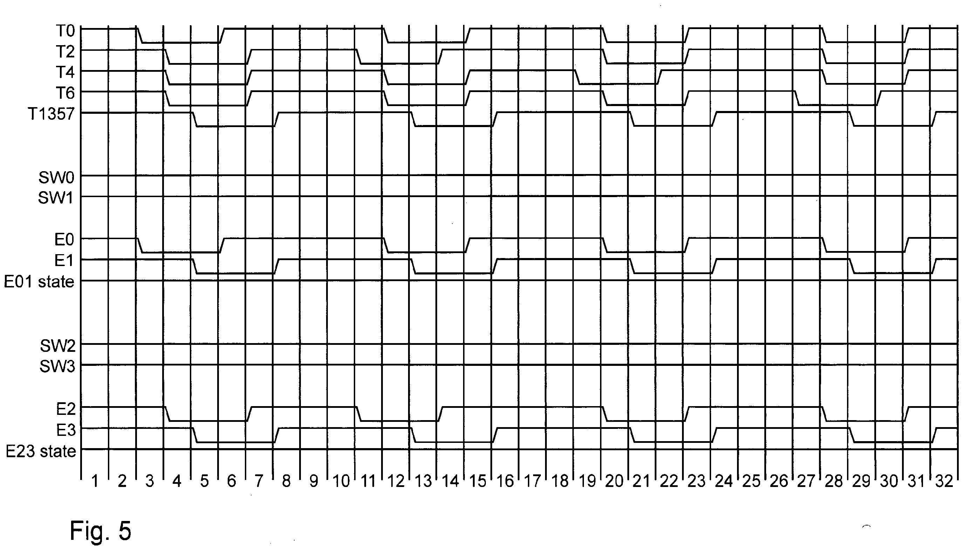

Bei dem in Figur 5 dargestellten Signalverlaufsdiagramm ist vorgesehen, dass in wenigstens einem Arbeitstakt alle Überwachungssignale einen logischen "Low"-Pegel einnehmen. Exemplarisch sind dies die Arbeitstakte 5, 13, 21, 29. Wird von einer der Auswerteschaltungen 25 bis 32 zu diesem Zeitpunkt dennoch ein logischer "High"-Pegel detektiert, so liegt ein Kurzschluss wenigstens einer der Leitungen 10 oder 11 zur Versorgungsspannung, also nach VCC, vor.

Ferner ist vorgesehen, dass jeder der Taktgeneratoren 19 bis 23 exemplarisch in einem Arbeitstakt allein zur Bereitstellung eines logischen "High"-Pegels aktiviert ist. In der Figur 5 sind dies exemplarisch die Arbeitstakte 4, 12, 20, 28 für den gemeinsamen Taktgenerator 23, der Arbeitstakt 6 für den ersten individuellen Taktgenerator 19, der Arbeitstakt 14 für den zweiten individuellen Taktgenerator 20, der Arbeitstakt 22 für den dritten individuellen Taktgenerator 21 und der Arbeitstakt 30 für den vierten individuellen Taktgenerator 22. Hier kann erkannt werden, welche Leitungen 8, 9 aktuell von diesem Takt versorgt werden, vor allem, welche durch einen Kurzschluss zwischen zwei Leitungen 8, 9, 10, 11 fälschlicherweise versorgt werden.

Ferner gibt es exemplarisch zwei Gruppen von Zeitabschnitten, in denen jeweils Folgendes gilt:
In der ersten Gruppe von Zeitabschnitten, exemplarisch in den Zeitabschnitten 7, 15, 23, 31, sind jeweils nur alle individuellen Taktgeneratoren 19 bis 22 aktiv.

In der zweiten Gruppe von Zeitabschnitten, exemplarisch in den Zeitabschnitten 4, 12, 20, 28, ist nur der gemeinsame Taktgenerator 23 aktiv.

Werden die Leitungen 10, 11 zwischen zwei Taktversorgungen umgeschaltet, so kann hier in jedem Arbeitstakt erkannt werden, ob die Leitung 10, 11 von einem der individuellen Taktgeneratoren 19 bis 22 oder vom gemeinsamen Taktgenerator 23 mit einem logischen "High"-Pegel versorgt werden. Die Arbeitstakte werden direkt aneinandergehängt, so dass jeder Takt in einem wiederkehrenden Zyklus von gleichartigen Arbeitstakten nur einmal aus- und eingeschaltet wird. Bei dieser Vorgehensweise ist vorteilhaft, dass die Anzahl der Schaltvorgänge gering gehalten wird, wodurch Vorteile für das elektromagnetische Abstrahlverhalten erzielt werden können. Vorzugweise ist vorgesehen, dass der Arbeitstakt mit allen Taktgeneratoren 19 bis 23 auf "Low"-Pegel von Arbeitstakten umrahmt wird, in denen die einzelnen Taktgeneratoren 19 bis 23 jeweils zeitweise einen "Low"-Pegel einnehmen.

Die einzelnen logischen Pegel können individuell verlängert werden, um gleiche Taktlängen zu erreichen. Dies kann für die an dieses System angeschlossenen Sensoren von Vorteil sein, z.B. wenn diese eine Mindestpulsdauer verlangen, so ist kein Puls länger als die verlangte Mindestpulsdauer.

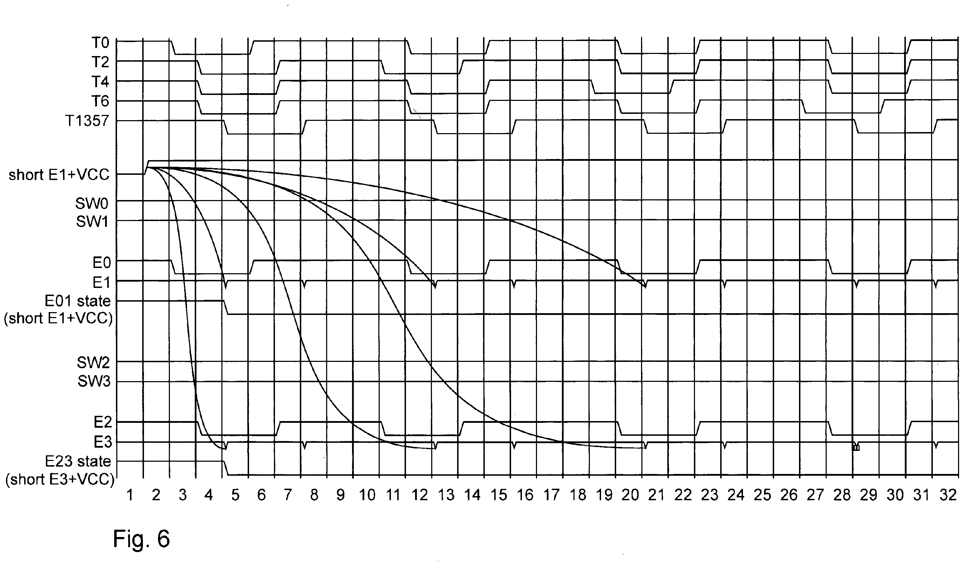

Das Signalverlaufsdiagramm gemäß der Figur 6 weist die gleiche Signalfolge wie das Signalverlaufsdiagramm gemäß der Figur 5, wobei nunmehr ein Fehlerfall betrachtet wird. Es wird davon ausgegangen, dass im Arbeitstakt 2 ein Kurzschluss zwischen der vierten Leitung 11 der ersten Sicherheitskomponente 50 des Sicherheitssystems 49 und der Versorgungsspannung (VCC) auftritt (short E1+VCC). Die Kurzschlusserkennung nach VCC erfolgt im Arbeitstakt 5, in dem alle Takte auf einem logischen "Low"-Pegel sind. Gelangt zu diesem Zeitpunkt dennoch ein Signal zu einer der in Figur 6 betrachteten Auswerteschaltungen 25 bis 28, so weist die zugeordnete Leitung 10, 11 einen Kurzschluss nach VCC auf und die Auswerteschaltungen 25 bis 28 setzen sowohl einen Status "E01 state" als auch einen Status "E23 state" auf einen logischen "Low"-Pegel, da in diesem Fehlerfall nicht unterschieden werden kann, welche der Leitungen 8 bis 11 einen Kurzschluss gegenüber VCC aufweist. Dies wird in der Figur 6 in den Arbeitstakten 5, 13, 21, 29 geprüft. Die Erkennung erfolgt also in jedem wiederkehrenden Zyklus von Arbeitstakten.

Bei einem Kurzschluss nach VCC an einer der Leitungen 11 liegt dort konstant VCC an. In Figur 6 liegt ein Kurzschluss zwischen der vierten Leitung 11 der ersten Sicherheitskomponente 50 und VCC vor. Dies wird in den Arbeitstakten 5, 13, 21, 29 gemessen und dadurch erkannt, dass das Signal an der Auswerteschaltung 25 entgegen der Erwartung auf einem logischen "High"-Pegel verbleibt. Die anderen Eingänge werden davon nicht beeinflusst.

Bei einem Kurzschluss nach VCC an einer der dritten Leitungen 10 liegt konstant VCC an allen Auswerteschaltungen 26, 28, 30, 32 an, der Kurzschluss kann nicht einem der Sicherheitskomponenten 50, 51, 52 oder 53 zugeordnet werden.

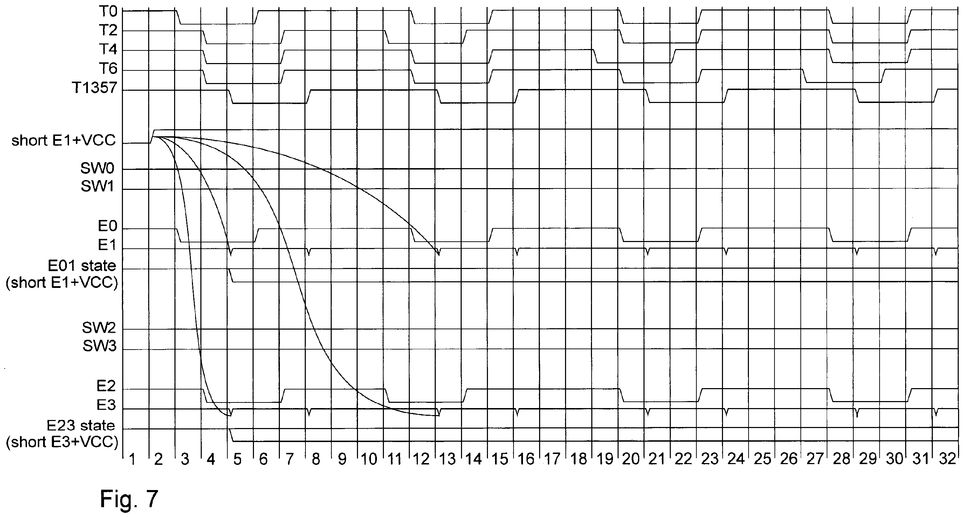

Bei dem Signalverlaufsdiagramm gemäß der Figur 7 wird davon ausgegangen, dass ein Kurzschluss zwischen den Leitungen 8 und 9 oder ein Kurzschluss zwischen den Leitungen 10 und 11 vorliegt. Um diesen Kurzschluss zu erkennen und von einem Kurzschluss nach VCC unterscheiden zu können, gibt es Arbeitstakte, in denen jeweils nur ein Taktgenerator 19 bis 23 eingeschaltet ist, während alle anderen Taktgeneratoren 19 bis 23 ausgeschaltet sind. In der Figur 7 ist der gemeinsame Taktgenerator 23 in den Arbeitstakten 4, 12, 20, 28 jeweils alleine eingeschaltet. Ist an einer der Leitungen 11 in diesem Arbeitstakt ein "High"-Pegel zu detektieren und im nachfolgenden Arbeitstakt (VCC-Kurzschluss-Prüfung) an der jeweiligen Leitung 11 ein "Low"-Pegel zu detektieren, so liegt ein Kurzschluss der jeweiligen Leitung 11 zum gemeinsamen Taktgenerator 23 vor. Dies ist im Beispiel in Figur 7 für die Leitung 11 der ersten Sicherheitskomponente 50 der Fall.

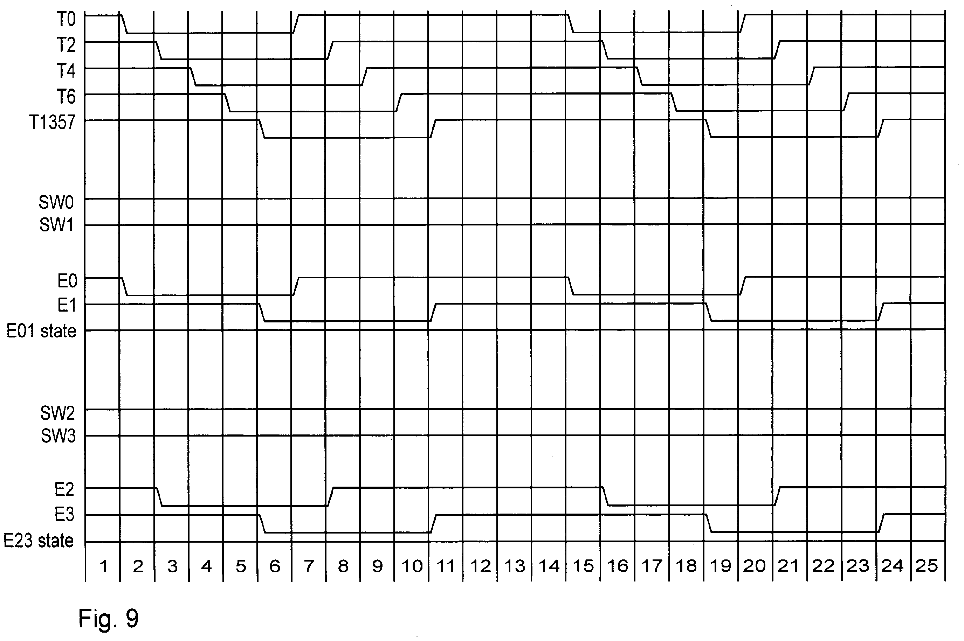

Alternativ können alle Takte mit gleicher Dauer aber jeweils etwas phasenversetzt verwendet werden, wie dies in der Figur 9 dargestellt ist. Somit ist immer für zwei Takte ein Bereich vorhanden, in dem jeweils nur einer von beiden an ist und ein weiterer Bereich, in dem beide an sind und ein weiterer Bereich, in dem beide aus sind.

In Figur 9 werden die fünf Taktgeneratoren 19 bis 23 jeweils um einen Arbeitstakt versetzt ab dem Arbeitstakt 2 ausgeschaltet und jeweils um einen Arbeitstakt versetzt ab dem Arbeitstakt 7 wieder eingeschaltet. Liegt beispielsweise ein Kurzschluss zwischen dem Taktgenerator 20 und dem gemeinsamen Taktgenerator 23 vor, so wird die Leitung 11 für die zweite Sicherheitskomponente 51 fälschlicherweise erst zum Arbeitstakt 6 ausgeschaltet, es liegt folglich ein Fehler vor.

Beim Einschalten ist es umgekehrt, hier werden beim Einschalten des Taktgenerators 20 auch Leitungen 10 der mit dem gemeinsamen Taktgenerator 23 verbundenen Sicherheitskomponenten 40, 51, 52 und 53 mit eingeschaltet, es liegt folglich ebenfalls ein Fehler vor.

Es liegen wieder Arbeitstakte 6 und 19 vor, in denen alle Taktgeneratoren 19 bis 23 aus sind und in denen der Kurzschluss nach VCC von Kurzschlüssen zu anderen Taktsignalen unterschieden werden kann.

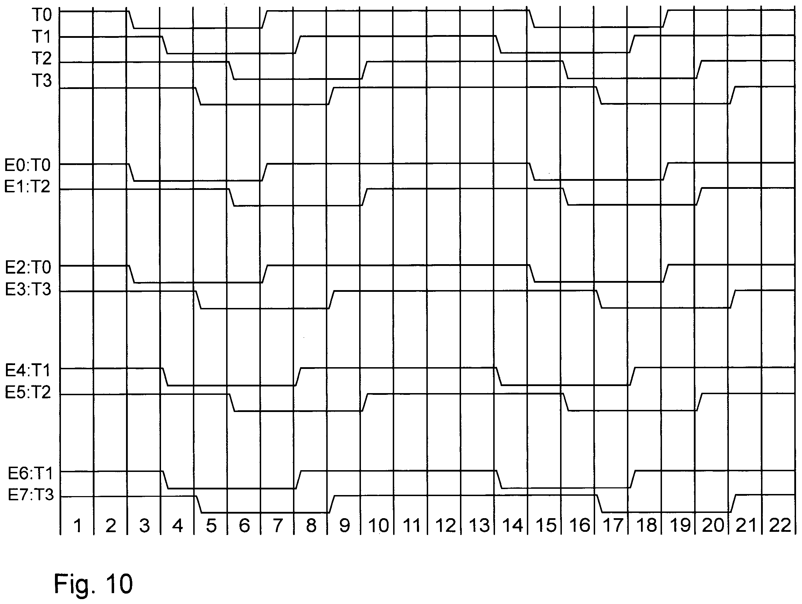

Das Signalverlaufsdiagramm gemäß der Figur 10 zeigt einen möglichen Signalverlauf für das Sicherheitssystem 59 gemäß der Figur 3. Wie bereits obenstehend angeführt wurde, ist beim Sicherheitssystem 59 gemäß der Figur 3 kein Taktgenerator für alle ersten oder zweiten Ausgangsanschlüsse 15, 16 vorgesehen, vielmehr ist an jeder Schnittstelle 3 eine individuelle Kombination von Taktgeneratoren 19 bis 22 mit den jeweiligen Sicherheitskomponenten 60, 61, 62 und 63 verbunden. Im Signalverlaufsdiagramm gemäß der Figur 10 sind die Überwachungssignale T0, T1, T2 und T3 dargestellt, die an die jeweiligen Ausgangsanschlüsse 15, 16 angelegt werden. Ferner sind die an den Auswerteschaltungen 25 bis 32 eintreffenden Überwachungssignale E0 bis E7 eingezeichnet, die jeweils von den bereitgestellten Überwachungssignalen T0 bis T3 gespeist werden, was durch die Notation E0:T0, E1:T2 usw. gekennzeichnet ist. Übereinstimmend mit den Signalverlaufsdiagrammen gemäß den Figuren 4 bis 9 sind auch beim Signalverlaufsdiagramm gemäß der Figur 10 jeweils Arbeitstakte vorgesehen, in denen die Taktgeneratoren 19 bis 22 nur Überwachungssignale mit einem logischen "Low"-Pegel ausgeben. Exemplarisch ist dies in den Arbeitstakten 6 und 17 der Fall. Damit kann in der gleichen Weise wie bei den Signalverlaufsdiagrammen in den Figuren 4 bis 9 ermittelt werden, ob ein Kurzschluss gegenüber einer Versorgungsspannung vorliegt.

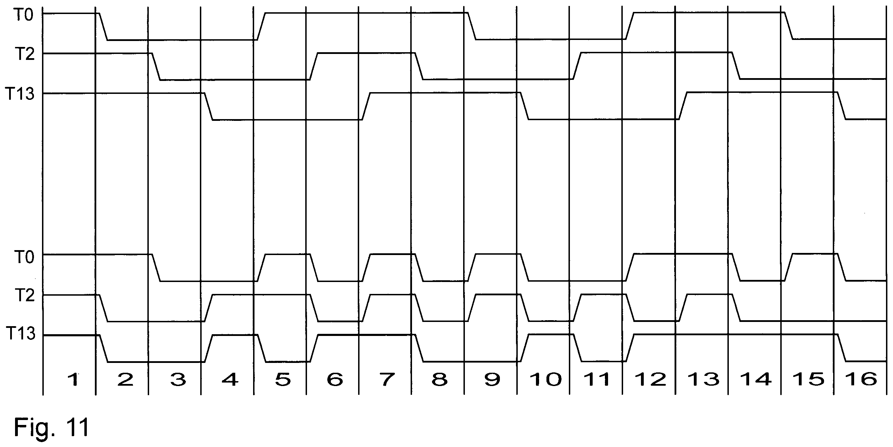

Aus dem Signalverlaufsdiagramm gemäß der Figur 11 ist zu entnehmen, dass die Überprüfung der Leitungen eines Sicherheitssystems 1, 49 oder 59 unabhängig von regelmäßigen oder unregelmäßigen Signalverläufen ist, da es lediglich darauf ankommt, dass innerhalb eines vorgegebenen Prüfzeitraum sämtliche logischen Pegel-Kombinationen von Überwachungssignalen auftreten.

Die nachfolgende Tabelle zeigt eine Kombination sämtlicher Signalzustände für eine zeichnerisch nicht dargestellte Überwachungsvorrichtung, bei der an zwei Schnittstellen jeweils zwei Ausganganschlüsse vorgesehen sind. Dabei ist vorgesehen, dass ein erster Taktgenerator T0 mit einem ersten Ausgangsanschluss der ersten Schnittstelle verbunden ist, ein zweiter Taktgenerator mit einem ersten Ausgangsanschluss einer zweiten Schnittstelle verbunden ist und ein dritter Taktgenerator mit beiden zweiten Ausgangsanschlüssen beider Schnittstellen verbunden ist. Jeder Taktgenerator kann wahlweise ein Überwachungssignal mit einem "High"-Pegel, der in der Tabelle als "1" gekennzeichnet ist, oder mit einem "Low"-Pegel, der in der Tabelle als "0" gekennzeichnet ist, ausgeben. Für eine vollständige Überwachung sind zumindest die Signalkombinationen an den Ausgangsanschlüssen anzulegen, die in der Spalte "Notwendig" mit "x" gekennzeichnet sind.

| Notwendig | T0 | T2 | T13 |
|---|---|---|---|
| x | 1 | 0 | 0 |
| | 1 | 1 | 0 |
| x | 0 | 1 | 0 |
| x | 0 | 1 | 1 |
| | 1 | 1 | 1 |
| | 1 | 0 | 1 |
| | 0 | 0 | 1 |
| x | 0 | 0 | 0 |

## Patentansprüche

1. Überwachungsvorrichtung zur Überwachung von Sicherheitskomponenten (40 bis 43; 50 bis 53; 60 bis 63), mit einer Überwachungselektronik (2), die mehrere Taktgeneratoren (19 bis 23) und Auswertemittel (25 bis 32) umfasst und an der wenigstens zwei zu überwachende Schnittstellen (3) für eine elektrische Kopplung mit Sicherheitskomponenten (40 bis 43; 50 bis 53; 60 bis 63) ausgebildet sind, wobei jede der Schnittstellen (3) wenigstens zwei Ausgangsanschlüsse und wenigstens zwei Eingangsanschlüsse umfasst (15 bis 18), wobei ein erster Ausgangsanschluss und ein zweiter Ausgangsanschluss jeweils mit einem Taktgenerator verbunden (19 bis 23) ist, der für eine Bereitstellung von getakteten elektrischen Überwachungssignalen ausgebildet ist, wobei ein erster Eingangsanschluss und ein zweiter Eingangsanschluss mit den Auswertemitteln (25 bis 32) verbunden sind, die für eine Auswertung von eintreffenden Überwachungssignalen und für eine Ausgabe einer Fehlermeldung bei einem Ausbleiben von bereitgestellten Überwachungssignalen ausgebildet sind, wobei eine Anzahl von Taktgeneratoren größer als Zwei und kleiner als eine Anzahl sämtlicher Ausgangsanschlüsse der zu überwachenden Schnittstellen gewählt ist, **dadurch gekennzeichnet, dass** der erste Ausgangsanschluss (15, 16) jeder Schnittstelle (3) mit einem individuell zugeordneten Taktgenerator (19 bis 22) verbunden ist und dass zweite Ausgangsanschlüsse (15, 16) von wenigstens zwei Schnittstellen (3) mit einem gemeinsamen Taktgenerator (23) verbunden sind.

2. Überwachungsvorrichtung nach Anspruch 1, **dadurch gekennzeichnet, dass** der weitere Taktgenerator (23) mit sämtlichen zweiten Ausgangsanschlüssen der zu überwachenden Schnittstellen (3) verbunden ist.

3. Überwachungsvorrichtung nach Anspruch 1, **dadurch gekennzeichnet, dass** die Schnittstelle (3) genau zwei Ausgangsanschlüsse (15 bis 18) und genau zwei Eingangsanschlüsse umfasst und ein erster Ausgangsanschluss (15) mit dem individuell zugeordneten Taktgenerator (19 bis 22) verbunden ist und ein zweiter Ausgangsanschluss (16) mit dem weiteren Taktgenerator (23) verbunden ist und ein erster Eingangsanschluss (17) mit den Auswertemitteln (25 bis 32) verbunden ist und ein zweiter Eingangsanschluss (18) mit den Auswertemitteln (25 bis 32) verbunden ist.

4. Sicherheitssystem mit einer Überwachungsvorrichtung (2) nach einem der vorhergehenden Ansprüche und mit wenigstens einer Sicherheitskomponente (40 bis 43; 50 bis 53; 60 bis 63), die Anschlussmittel (4) zur Verbindung mit der Schnittstelle der Überwachungsvorrichtung (2) umfasst, wobei die Anschlussmittel (4) wenigstens vier elektrische Leitungen (8 bis 11) umfassen, die jeweils paarweise zur elektrischen Ankopplung eines zu überwachenden Funktionselements (6, 7; 54; 64, 65), insbesondere eines Schalters oder eines Sensors, ausgebildet sind.

5. Verfahren zum Betreiben eines Sicherheitssystems, insbesondere nach Anspruch 4, wobei an Schnittstellen (3) einer Überwachungsvorrichtung (2) jeweils Sicherheitskomponenten (40 bis 43; 50 bis 53; 60 bis 63) angeschlossen sind, wobei jede der Schnittstellen (3) wenigstens zwei Ausgangsanschlüsse und wenigstens zwei Eingangsanschlüsse umfasst (15 bis 18) und wobei die Überwachungsvorrichtung (2) wenigstens zwei Taktgeneratoren (19 bis 23) umfasst, die zur Bereitstellung von Überwachungssignalen an Ausgangsanschlüsse der Schnittstellen (3) ausgebildet sind, und mit Auswertemitteln (25 bis 32) zur Überwachung von Eingangsanschlüssen (15 bis 18) der Schnittstellen (3) auf ein Eintreffen von ausgesendeten Überwachungssignalen, wobei die wenigstens zwei Taktgeneratoren (19 bis 23) derart betrieben werden, dass in wiederkehrendenden Zeitabschnitten die von den wenigstens zwei Taktgeneratoren (19 bis 23) an die Schnittstellen (3) bereitgestellten Überwachungssignale einen Signalpegel unterhalb einer vorgebbaren Ansprechschwelle der Auswertemittel (25 bis 32) aufweisen, **dadurch gekennzeichnet, dass** jedem ersten Ausgangsanschluss der zu überwachenden Schnittstellen ein Taktgenerator (19 bis 23) zur Bereitstellung wenigstens eines individuellen Überwachungssignals zugeordnet ist und dass wenigstens ein Taktgenerator (19 bis 23) mit zweiten Ausgangsanschlüssen von wenigstens zwei Schnittstellen (3) verbunden ist, um ein gemeinsames Überwachungssignal an diese zweiten Ausgangsanschlüsse bereitzustellen, wobei zu einem vorgebbaren ersten Zeitpunkt alle individuellen Überwachungssignale und wenigstens ein gemeinsames Überwachungssignal an den Schnittstellen (3) bereitgestellt werden.

6. Verfahren nach Anspruch 5, **dadurch gekennzeichnet, dass** die individuellen Überwachungssignale und/oder das wenigstens eine gemeinsame Überwachungssignal zyklisch wiederkehrend an die jeweiligen Schnittstellen (3) bereitgestellt werden.

7. Verfahren nach Anspruch 5 oder 6, **dadurch gekennzeichnet, dass** die Taktgeneratoren (19 bis 23) für die Bereitstellung der Überwachungssignale zeitversetzt zueinander aktiviert und deaktiviert werden.

8. Verfahren nach einem der Ansprüche 5 bis 7, **dadurch gekennzeichnet, dass** zu einem vorgebbaren zweiten Zeitpunkt an den Schnittstellen (3) kein individuelles Überwachungssignal anliegt.

9. Verfahren nach einem der Ansprüche 5 bis 8, **dadurch gekennzeichnet, dass** zu einem vorgebbaren dritten Zeitpunkt an den jeweiligen Schnittstellen (3) kein gemeinsames Überwachungssignal anliegt.

10. Verfahren nach einem der Ansprüche 5 bis 9, **dadurch gekennzeichnet, dass** die Taktgeneratoren (19 bis 23) derart betrieben werden, dass zu einem vorgebbaren vierten Zeitpunkt an wenigstens einer Schnittstelle (3) kein individuelles Überwachungssignal und kein gemeinsames Überwachungssignal bereitgestellt werden.

11. Verfahren nach einem der Ansprüche 5 bis 9, **dadurch gekennzeichnet, dass** zu einem vorgebbaren Zeitpunkt ausschließlich an einer einzigen Schnittstelle (3) ein individuelles Überwachungssignal anliegt und/oder dass Zykluszeiten für die Bereitstellung der Überwachungssignale abweichend voneinander gewählt sind.

12. Verfahren nach einem der Anspruch 5 bis 11, **dadurch gekennzeichnet, dass** wenigstens ein Taktgenerator (23) dauerhaft aktiviert wird und das hierdurch bereitgestellte Überwachungssignal zur elektrischen Versorgung der Sicherheitskomponente (40 bis 43; 50 bis 53; 60 bis 63) dient.

## Claims

1. Monitoring device for monitoring safety components (40 to 43; 50 to 53; 60 to 63), comprising monitoring electronics (2) which include a plurality of clock generators (19 to 23) and evaluation means (25 to 32) and on which at least two interfaces (3) to be monitored for electric coupling to safety components (40 to 43; 50 to 53; 60 to 63) are formed, wherein each of the interfaces (3) comprises at least two output ports and at least two input ports (15 to 18), wherein each of a first output port and a second output port is connected to a clock generator (19 to 23) designed for providing clocked electric monitoring signals, wherein a first input port and a second input port are connected to the evaluation means (25 to 32) designed for an evaluation of incoming monitoring signals and for an output of a fault message when provided monitoring signals fail to appear, **characterised in that** a number of clock generators greater than two and less than a number of all output ports of the interfaces to be monitored is chosen, **characterised in that** the first output port (15, 16) of each interface (3) is connected to an individually assigned clock generator (19 to 22), and **in that** second output ports (15, 16) of at least two interfaces (2) are connected to a common clock generator (23).

2. Monitoring device according to claim 1, **characterised in that** the further clock generator (23) is connected to all second output ports of the interfaces (3) to be monitored.

3. Monitoring device according to claim 1, **characterised in that** the interface (3) has precisely two output ports (15 to 18) and precisely two input ports, and **in that** a first output port (15) is connected to the individually assigned clock generator (19 to 22) and a second output port (16) is connected to the further clock generator (23), and **in that** a first input port (17) is connected to the evaluation means (25 to 32) and a second input port (18) is connected to the evaluation means (25 to 32).

4. Safety system comprising a monitoring device (2) according to any of the preceding claims and at least one safety component (40 to 43; 50 to 53; 60 to 63) which comprises connecting means (4) for connection to the interface of the monitoring device (2), the connecting means (4) comprising at least four electric lines (8 to 11) designed in pairs for the electric coupling of a functional element (6, 7; 54; 64, 65) to be monitored, in particular a switch or a sensor.

5. Method for operating a safety system, in particular a safety system according to claim 4, wherein safety components (40 to 43; 50 to 53; 60 to 63) are connected to each interface (3) of a monitoring device (2), wherein each of the interfaces (3) comprises at least two output ports and at least two input ports (15 to 18) and wherein the monitoring device (2) comprises at least two clock generators (19 to 23) which are designed for making available monitoring signals to output ports of the interfaces (3), and evaluation means (25 to 32) for monitoring input ports (15 to 18) of the interfaces (3) for an arrival of transmitted monitoring signals, **characterised in that** the at least two clock generators (19 to 23) are operated in such a way that, in recurring periods of time, the monitoring signals made available to the interfaces (3) by the at least two clock generators (19 to 23) have a signal level below a presettable response threshold of the evaluation means (25 to 32), **characterised in that** each first output port of the interfaces to be monitored is assigned a clock generator (19 to 23) for the provision of at least one individual monitoring signal, and **in that** at least one clock generator (19 to 23) is connected to second output ports of at least two interfaces (3) for making available a common monitoring signal to these second output ports, wherein at a presettable first point in time all individual monitoring signals and at least one common monitoring signal are made available at the interfaces (3).

6. Method according to claim 5, **characterised in that** the individual monitoring signals and / or the at least one common monitoring signal is / are made available to the respective interfaces (3) in cyclic recurrence.

7. Method according to claim 5 or 6, **characterised in that** the clock generators (19 to 23) for the provision of the monitoring signals are activated and deactivated in a time-offset manner.

8. Method according to any of claims 5 to 7, **characterised in that** no individual monitoring signal is applied to the interfaces (3) at a presettable second point in time.

9. Method according to any of claims 5 to 8, **characterised in that** no common monitoring signal is applied to the interfaces (3) at a presettable third point in time.

10. Method according to any of claims 5 to 9, **characterised in that** the clock generators (19 to 23) are operated in such a way that at least one interface (3) receives no individual monitoring signal and no common monitoring signal at a presettable fourth point in time.

11. Method according to any of claims 5 to 9, **characterised in that** an individual monitoring signal is applied to a single interface (3) only at a presettable point in time, and / or **in that** cycle times for the provision of the monitoring signals are chosen to differ from one another.

12. Method according to any of claims 5 to 11, **characterised in that** at least one clock generator (23) is permanently activated and the monitoring signal made available thereby is used for the electric supply of the safety component (40 to 43; 50 to 53; 60 to 63).

## Revendications

1. Dispositif de surveillance servant à surveiller des composants de sécurité (40 à 43 ; 50 à 53 ; 60 à 63), avec une électronique de surveillance (2), qui comprend plusieurs générateurs d'horloge (19 à 23) et des moyens d'analyse (25 à 32) et au niveau de laquelle au moins deux interfaces (3) à surveiller sont réalisées en vue d'un couplage électrique avec des composants de sécurité (40 à 43 ; 50 à 53 ; 60 à 63), dans lequel chacune des interfaces (3) comprend au moins deux bornes de sortie et au moins deux bornes d'entrée (15 à 18), dans lequel une première borne de sortie et une deuxième borne de sortie sont reliées respectivement à un générateur d'horloge (19 à 23), qui est réalisé en vue d'une fourniture de signaux de surveillance électriques cadencés, dans lequel une première borne d'entrée et une deuxième borne d'entrée sont reliées aux moyens d'analyse (25 à 32), qui sont réalisés en vue d'une analyse de signaux de surveillance entrants et en vue d'une émission d'un message d'erreur à défaut de signaux de surveillance fournis, cependant 'un nombre de générateurs d'horloge est choisi supérieur à deux et inférieur à un nombre de toutes les bornes de sortie des interfaces à surveiller, **caractérisé en ce que** la première borne de sortie (15, 16) de chaque interface (3) est reliée à un générateur d'horloge (19 à 22) associé individuellement, et que des deuxièmes bornes de sortie (15, 16) d'au moins deux interfaces (3) sont reliées à un générateur d'horloge (23) commun.

2. Dispositif de surveillance selon la revendication 1, **caractérisé en ce que** l'autre générateur d'horloge (23) est relié à toutes les deuxièmes bornes de sortie des interfaces (3) à surveiller.

3. Dispositif de surveillance selon la revendication 1, **caractérisé en ce que** l'interface (3) comprend précisément deux bornes de sortie (15 à 18) et précisément deux bornes d'entrée, et une première borne de sortie (15) est reliée au générateur d'horloge (19 à 22) associé de manière individuelle et une deuxième borne de sortie (16) est reliée à l'autre générateur d'horloge (23) et une première borne d'entrée (17) est reliée aux moyens d'analyse (25 à 32) et une seconde borne d'entrée (18) est reliée aux moyens d'analyse (25 à 32).

4. Système de sécurité avec un dispositif de surveillance (2) selon l'une quelconque des revendications précédentes et avec au moins un composant de sécurité (40 à 43 ; 50 à 53 ; 60 à 63), qui comprend des moyens de raccordement (4) destinés à être reliés à l'interface du dispositif de surveillance (2), dans lequel les moyens de raccordement (4) comprennent au moins quatre lignes (8 à 11) électriques, qui sont réalisées respectivement par paires aux fins de l'accouplement électrique d'un élément fonctionnel (6, 7 ; 54 ; 64, 65) à surveiller, en particulier d'un commutateur ou d'un capteur.

5. Procédé servant à faire fonctionner un système de sécurité, en particulier selon la revendication 4, dans lequel respectivement des composants de sécurité (40 à 43 ; 50 à 53 ; 60 à 63) sont raccordés à des interfaces (3) d'un dispositif de surveillance (2), dans lequel chacune des interfaces (3) comprend au moins deux bornes de sortie et au moins deux bornes d'entrée (15 à 18) et dans lequel le dispositif de surveillance (2) comprend au moins deux générateurs d'horloge (19 à 23), qui sont réalisés afin de fournir des signaux de surveillance aux bornes de sortie des interfaces (3), et avec des moyens d'analyse (25 à 32) servant à surveiller l'arrivée de signaux de surveillance émis sur des bornes d'entrée (15 à 18) des interfaces (3), cependant les deux générateurs d'horloge (19 à 23) ou plus fonctionnent de telle manière que les signaux de surveillance fournis par les deux générateurs d'horloge (19 à 23) ou plus aux interfaces (3) présentent, à des intervalles de temps récurrents, un niveau de signal inférieur à un seuil de réponse pouvant être spécifié des moyens d'analyse (25 à 32), **caractérisé en ce qu'**un générateur d'horloge (19 à 23) servant à fournir au moins un signal de surveillance individuel est associé à chaque première borne de sortie des interfaces à surveiller, et qu'au moins un générateur d'horloge (19 à 23) est relié à des deuxièmes bornes de sortie d'au moins deux interfaces (3) afin de fournir un signal de surveillance commun auxdites deuxièmes bornes de sortie, dans lequel tous les signaux de surveillance individuels et au moins un signal de surveillance commun sont fournis aux interfaces (3) à un premier moment pouvant être spécifié.

6. Procédé selon la revendication 5, **caractérisé en ce que** les signaux de surveillance individuels et/ou l'au moins un signal de surveillance commun sont fournis de manière cyclique et récurrente aux interfaces (3) respectives.

7. Procédé selon la revendication 5 ou 6, **caractérisé en ce que** les générateurs d'horloge (19 à 23) sont activés et désactivés avec un décalage dans le temps en vue de la fourniture des signaux de surveillance.

8. Procédé selon l'une quelconque des revendications 5 à 7, **caractérisé en ce qu'**aucun signal de surveillance individuel n'est appliqué sur les interfaces (3) à un deuxième moment pouvant être spécifié.

9. Procédé selon l'une quelconque des revendications 5 à 8, **caractérisé en ce qu'**aucun signal de surveillance commun n'est appliqué aux interfaces (3) respectives à un troisième moment pouvant être spécifié.

10. Procédé selon l'une quelconque des revendications 5 à 9, **caractérisé en ce que** les générateurs d'horloge (19 à 23) fonctionnent de telle manière qu'aucun signal de surveillance individuel et aucun signal de surveillance commun ne sont fournis à au moins une interface (3) à un quatrième moment pouvant être spécifié.

11. Procédé selon l'une quelconque des revendications 5 à 9, **caractérisé en ce qu'**un signal de surveillance individuel est appliqué exclusivement sur une unique interface (3) à un moment pouvant être spécifié, et/ou que des délais de cycle sont choisis de manière différente les uns des autres en vue de la fourniture des signaux de surveillance.

12. Procédé selon l'une quelconque des revendications 5 à 11, **caractérisé en ce qu'**au moins un générateur d'horloge (23) est activé de manière durable et le signal de surveillance fourni par celui-ci sert à l'alimentation électrique des composants de sécurité (40 à 43 ; 50 à 53 ; 60 à 63).
